Europäisches Patentamt

European Patent Office

Office européen des brevets

(11) Publication number: **0 267 831**
A1

# EUROPEAN PATENT APPLICATION

(21) Application number: 87402317.9

(22) Date of filing: 16.10.87

(51) Int. Cl.⁴: **H 01 L 21/90**

(30) Priority: 17.10.86 US 920249

(43) Date of publication of application:
18.05.88 Bulletin 88/20

(84) Designated Contracting States:
DE ES FR GB IT NL

(71) Applicant: THOMSON COMPONENTS-MOSTEK
CORPORATION
1310 Electronics Drive
Carrollton Texas 75006 (US)

(72) Inventor: Simpson, Dale A.
THOMSON-CSF SCPI 19, avenue de Messine
F-75008 Paris (FR)

Miller, Robert O.
THOMSON-CSF SCPI 19, avenue de Messine
F-75008 Paris (FR)

(74) Representative: Ruellan-Lemonnier, Brigitte et al
THOMSON-CSF SCPI 19, avenue de Messine
F-75008 Paris (FR)

(54) Double level metal planarization technique.

(57) A two level metallization process which uses conformal deposition of silicon nitride (27) of sufficient thickness to fill completely narrow valleys (20) resulting from closely spaced steps in the oxide layer used as the intermetal dielectric. With the filling of the narrow valleys, a smooth surface is formed for the second metal layer.

FIG.2

EP 0 267 831 A1

**Description**

DOUBLE LEVEL METAL PLANARIZATION TECHNIQUE

FIELD OF THE INVENTION

This invention relates to the fabrication of semiconductive integrated circuits.

BACKGROUND OF THE INVENTION

In the manufacture of high density integrated circuits, it is now common to employ at least two levels of metallization, or layers of metal, which are patterned to provide electrical connections to various regions of the semiconductor substrate.

In such devices, it is also common to try to smooth the underlying surface topography before deposit of the second metal layer to insure good step coverage by this second layer to avoid the tendency for breaks to develop in such second layer in regions of steps. Existing processes to this end have various problems particularly when the first metal has features which are closely spaced.

In a process in accordance with the present invention, a film of silicon oxide is deposited over the first metal layer to serve as an insulator between the first and second metal layers. Planarization is achieved by conformally depositing a relatively thick film of silicon nitride over the oxide. In particular, the thickness is such that small valleys or openings in the oxide film are completely filled to leave the surface formed by the silicon oxide and silicon nitride free of any sharp steps. Next the nitride film is selectively etched until the oxide covering the first metal lines are exposed, whereby there is left a smooth surface for the second metal layer. The forming of vias in the intermetal insulating layers, deposition of the second metal layer and petterning of such second metal layer are done in conventional fashion.

The invention will be better understood from the following more detailed description taken in conjunction with the accompanying drawing.

BRIEF DESCRIPTION OF THE DRAWING

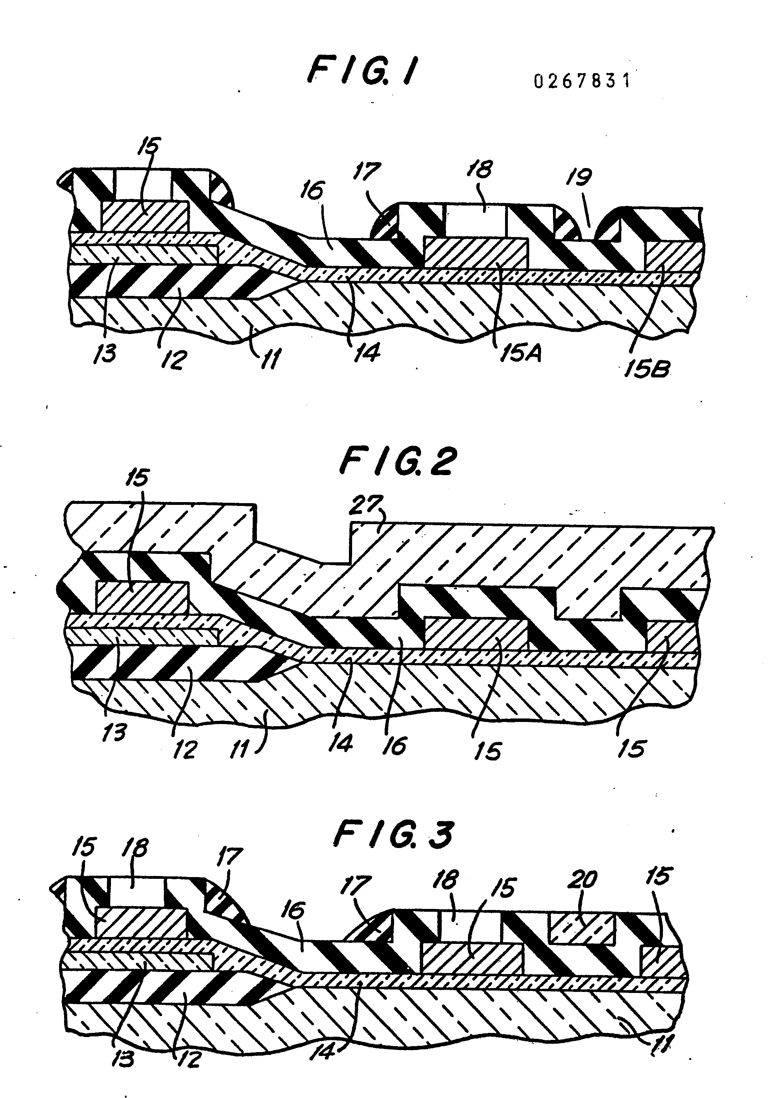

In the drawing, Fig. 1 represents the workpiece in a critical step in the prior art process.

Fig. 2 shows the workpiece in an intermediate step of the process in accordance with the present invention; and

Fig. 3 shows the workpiece in a subsequent step of the same process preliminary to the deposition of the second metal layer.

DETAILED DESCRIPTION OF THE DRAWING

In FIG. 1, there is shown a substrate 11, typically silicon, which is provided with various zones of particular conductivity types to define particular circuit characteristics at an intermediate step in a typical process before the step of depositing the second layer of metal. Overlying the substrate is the relatively thick field silicon oxide layer 12 typically about 6000 A units thick. In MOS devices, there will also be regions of relatively thin silicon oxide to define the gate regions (not shown).

A layer of polysilicon 13 optimally overlies portions of the workpiece. Such layer can serve to provide the gate electrode in MOS devices. Additionally, the workpiece typically will include a layer of insulating material 14, typically of a silicon compound such as phosphosilicate glass which serves to insulate portions of the patterned first metal layer 15 from the substrate 11. The workpiece further includes the intermetal dielectric layer 16, typically a deposited silicon oxide of about 5,000 A thickness, which is provided with vias or openings 18 where electronic connections are desired between the to-be-deposited second metal layer and the first metal layer 15. Also shown are the sidewall tabs or fillets 17 provided at vertical steps in the layer 16 to provide a relatively smooth surface over which deposit such second metal layer. When two steps are closely spaced, because two metal portions are closely spaced as are the portions 15A and 15B, the tabs 17 will tend to form cusps 19 in the narrow valley formed in the oxide layer, as shown, which are a potential source of problems apt to lead to device failure. Typically, the tabs 17 will have been formed by depositing a relatively thin layer of silicon nitride and then anisotropically removing it to leave only the tabs.

In FIG. 2, there is shown the same workpiece at essentially the same point in the process as that of Fig. 1. However, in this instance, in accordance with the invention, a relatively thick layer of silicon nitride 27 is deposited over the intermetal oxide layer 16 so that the narrow valley or opening between metal portions 15 A and 15 B is completely filled. Typically, this layer should have a thickness at least of about 7,000 A. This will happen if there be employed for the silicon nitride deposition a process that will provide conformal coverage, such as by chemical vapor deposition, conformal coverage being the buildup of the deposited material on all surfaces at nearly the same rate, so that the deposit on the side walls of a narrow opening will grow together as the vertical surfaces meet.

Although silicon oxide, silicon nitride and polysilicon all may be deposited conformally under appropriate deposition conditions, temperatures in excess of 450 C generally need to be avoided because of the tendency to form hillocks and to distant aluminum, which typically forms the first level of metal in two level systems. This temperature limitation makes it impractical to deposit silicon oxide conformally although lower temperatures are practical for silicon nitride, particularly in chemical vapor deposition processes employed plasma enhanced reactions, as known to workers in the art.

After the point shown in FIG. 2 is reached, the workpiece is exposed to a plasma or reactive ion etching, which etches the silicon nitride preferentially over higher elevations of silicon oxide until the oxide 16 covering the first metal portions 145 is exposed and there is reached the situation shown in FIG. 3. As shown there, the silicon nitride tabs 17 are formed at the side walls of the steps in oxide 16 but small openings where there were previously formed silicon nitride cusps 19 as shown in FIG. 1 are now completely filled with silicon nitride as shown at region 20 in Fig. 3.

Thereafter, the processing can continue in conventional fashion, the valley filled surface shown in FIG. 3 providing a smoother surface for the second level metal. Preliminary to deposition and patterning of the second level metal layer, it is usual to form openings in the oxide layer 16 where connections are desired between portions of the first and second levels of metal, as shown at region 18 in FIG. 3. Typically, a uniform layer of the second metal, typically aluminum is deposited for example by evaporation, and then patterned in the usual fashion. Care typically needs be taken to get good wall coverage of the second metal in regions 18 where connection to the first metal portions is being made.

It should be understood that the embodiment described is merely exemplary of the general principles involved. Variations will be feasible without departing from the spirit and scope of the invention.

## Claims

1. In a process for manufacturing semiconductive integrated circuit devices including two levels of metallization which are spaced apart by an intermetal dielectric comprising the steps of forming over a semiconductive substrate in turn a layer of a first metal which is patterned to form the first level of metallization, a layer of a dielectric to form the intermetal dielectric, and a layer of a second metal which is patterned to form the second level of metallization, the improvement which comprises depositing over the layer of intermetal dielectric a relatively thick smoothing layer of a different dielectric material to smooth steps in the intermetal layer and to fill completely narrow valleys arising between closely spaced steps in the intermetal layer, and preferentially etching the smoothing layer to remove it over intermetal dielectric layer and expose the intermetal layer except at adjacent steps in the intermetal layer and in said, narrow valleys.

2. The process of claim 1 in which the intermetal dielectric is silicon oxide and the smoothing layer material is silicon nitride.

3. The process of claim 2 in which the silicon nitride is deposited by a conformal coverage process and preferentially etched by plasma etching.

*F I G. I*

0267831

15 17 18 19 16 15A 15B 13 12 11 14

*F I G. 2*

15 27 13 12 11 14 16 15 15

*F I G. 3*

15 18 17 17 18 15 20 15 16 13 12 14 11

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | EP-A-0 154 419 (FUJITSU) * Figures 1a-1d; page 4, line 32 - page 9, line 1 * --- | 1 | H 01 L 21/90 |
| A | PATENT ABSTRACTS OF JAPAN, vol. 5, no. 159 (E-77)[831], 14th October 1981; & JP-A-56 87 346 (NIPPON DENKI K.K.) 15-07-1981 * Abstract * --- | 1,2 | |
| A | SOLID STATE TECHNOLOGY, vol. 27, no. 4, April 1984, pages 191-196, Port Washington, New York, US; J. DIELEMAN et al.: "Plasma effluent etching: selective and non-damaging" * Figure 6 * --- | 3 | |
| A | EP-A-0 119 497 (TOSHIBA) * Figures 1a-1c; page 5, line 10 - page 6, line 22 * ----- | 1 | |

TECHNICAL FIELDS SEARCHED (Int. Cl.4)

H 01 L

The present search report has been drawn up for all claims

| Place of search | Date of completion of the search | Examiner |
|---|---|---|
| THE HAGUE | 03-02-1988 | MACHEK,J. |